# EUROPEAN PATENT APPLICATION

(11) **EP 4 276 055 A1**
(43) Date of publication of application: **15.11.2023**
(21) Application number: 21917741.7
(22) Date of filing: 27.12.2021
(51) Int. Cl.: B81B 1/00, B81B 7/02, G03F 7/004, G03F 7/023, G03F 7/027, G03F 7/031, G03F 7/037

(54) **HOLLOW STRUCTURE, ELECTRONIC COMPONENT USING SAME, AND NEGATIVE PHOTOSENSITIVE RESIN COMPOSITION**

(30) Priority: 07.01.2021 JP 2021001217
(71) Applicant: Toray Industries, Inc., Tokyo 103-8666 (JP)
(72) Inventor: KOYAMA, Yutaro, Otsu-shi, Shiga 520-8558 (JP); ARAKI, Hitoshi, Otsu-shi, Shiga 520-8558 (JP)
(74) Representative: Hoefer & Partner Patentanwälte mbB
(86) International application number: PCT/JP2021/048513
(87) International publication number: WO 2022/149521

(57) **Abstract**

The present invention provides a hollow structure having a low acid ion content and low wiring corrosion when stored in high-temperature, high-humidity conditions. The present invention relates to a hollow structure in which an organic film (I) having a film thickness of 5-30 um as a hollow structure support material and an organic film (II) having a film thickness of 5-30 um as a hollow structure roof material are layered in said order from the upper surface of a substrate having a metal wiring, wherein, when the organic film (I) and the organic film (II) are independently evaluated by the following method for evaluating ion elution amounts, the total of the ion elution amount of the organic film (I) and the ion elution amount of the organic film (II) is no more than 4,000 ppm. (Ion elution amount evaluation method) An organic film is placed in pure water having a mass 10 times that of the organic film and is extracted in hot water for 10-20 hours at 100-121 °C, after which the supernatant of the liquid extract is used as a sample solution. The sample solution and a target ion standard solution are introduced into an ion chromatography device, the concentrations of formate ions, acetate ions, propionate ions, and sulfate ions in the sample solution are determined by a calibration curve method, and a value obtained by converting the total of said concentrations into the mass of eluted ions relative to the mass of the organic film is used as the ion elution amount.

## Description

### TECHNICAL FIELD

The present invention relates to a hollow structure, an electronic component using the hollow structure, and a negative photosensitive resin composition.

### BACKGROUND ART

Electronic components such as MEMS (MICRO ELECTRO MECHANICAL SYSTEMS) are indispensable technologies for high-speed and high-quality communication of electronic devices. Among MEMS, a sensor, a noise filter, and the like require a hollow structure, and a photosensitive resin composition is used for a hollow structure support material and a hollow structure roof material (Patent Documents 1 to 3) .

### PRIOR ART DOCUMENT

### PATENT DOCUMENTS

Patent Document 1: Japanese Patent Laid-open Publication No. 2014-74773
Patent Document 2: Japanese Patent Laid-open Publication No. 2013-178526
Patent Document 3: International Publication No. 2016/158760

### SUMMARY OF THE INVENTION

### PROBLEMS TO BE SOLVED BY THE INVENTION

A hollow structure using a known photosensitive resin composition has a problem of high metal wiring corrosion under high temperature and high humidity conditions.

### SOLUTIONS TO THE PROBLEMS

In order to solve the above-described problems, the present invention relates to the following.

A hollow structure in which an organic film (I) having a film thickness of 5 to 30 um as a hollow structure support material; and an organic film (II) having a film thickness of 5 to 30 um as a hollow structure roof material are layered in this order from an upper surface of a substrate having a metal wiring, wherein when the organic film (I) and the organic film (II) are independently evaluated by the following ion elution amount evaluation method, a total of the ion elution amount of the organic film (I) and the ion elution amount of the organic film (II) is 4,000 ppm or less.

### (Ion elution amount evaluation method)

An organic film is placed in pure water having a mass of 10 times that of the organic film, and is extracted in hot water for 10 to 20 hours at 100 to 121°C, and after which the supernatant of the liquid extract is used as a sample solution. The sample solution and a target ion standard solution are introduced into an ion chromatography device, the concentrations of formate ions, acetate ions, propionate ions, and sulfate ions in the sample solution are determined by a calibration curve method, and a value obtained by converting the total concentrations into the mass of eluted ions relative to the mass of the organic film is used as the ion elution amount.

### EFFECTS OF THE INVENTION

The present invention can suppress metal wiring corrosion during storage under high temperature and high humidity conditions.

### BRIEF DESCRIPTION OF THE DRAWINGS

Fig. 1 illustrates a cross-sectional view of a hollow structure according to the present invention.
Fig. 2 is a diagram illustrating a cross section of an organic film used in the present invention.

### EMBODIMENTS OF THE INVENTION

The present invention relates to a hollow structure in which an organic film (I) having a film thickness of 5 to 30 um as a hollow structure support material; and an organic film (II) having a film thickness of 5 to 30 um as a hollow structure roof material are layered in this order from an upper surface of a substrate having a metal wiring, wherein when the organic film (I) and the organic film (II) are independently evaluated by the following ion elution amount evaluation method, a total of the ion elution amount of the organic film (I) and the ion elution amount of the organic film (II) is 4,000 ppm or less.

### (Ion elution amount evaluation method)

An organic film is placed in pure water having a mass of 10 times that of the organic film, and is extracted in hot water for 10 to 20 hours at 100 to 121°C, and after which the supernatant of the liquid extract is used as a sample solution. The sample solution and a target ion standard solution are introduced into an ion chromatography device, the concentrations of formate ions, acetate ions, propionate ions, and sulfate ions in the sample solution are determined by a calibration curve method, and a value obtained by converting the total concentrations into the mass of eluted ions relative to the mass of the organic film is used as the ion elution amount.

The hollow structure of the present invention is a hollow structure in which an organic film (I) as a hollow structure support material and an organic film (II) as a hollow structure roof material are layered in this order from the upper surface of a substrate having a metal wiring.

As the substrate having a metal wiring, silicon, silicon oxide, lithium tantalate, lithium niobate, gallium arsenide or the like on which aluminum wiring or copper wiring is formed is mainly used, but the substrate is not limited thereto.

When the total of the ion elution amounts when the organic film (I) and the organic film (II) are independently evaluated by the following an ion elution amount evaluation method is 4,000 ppm or less, corrosion of metal wiring in a hollow structure under high temperature and high humidity conditions can be suppressed, and when the total of the ion elution amounts is 2,000 ppm or less, it is more preferable from the viewpoint of corrosion suppression, when the total of the ion elution amounts is 1,000 ppm or less, and it is most preferable that the total of the ion elution amounts is 500 to 0 ppm. The lower detection limit in the following evaluation method is set to 0 ppm.

The ion elution amount evaluation method is specifically as follows.
Each organic film for evaluating the ion elution amount is evaluated by separating a predetermined amount from the hollow structure. The ion elution amount may be evaluated from the resin composition for forming each organic film. When the ion elution amount is evaluated from the resin composition for forming each organic film, a cured product obtained by heat-treating a liquid or sheet-like resin composition may be used. Examples of a method for creating a cured product include a method in which a resin composition is applied or layered on a silicon substrate and heat-treated in an oven, and the resin composition is immersed in an aqueous hydrofluoric acid solution and peeled off, and a method in which a resin sheet formed on polyethylene terephthalate (PET) is transferred to a polytetrafluoroethylene (PTFE) film heated on a hot plate using a rubber roller, then heat-treated, and peeled off from the PTFE film.

The prepared cured product is freeze-pulverized using liquid nitrogen, then 1.0 to 2.0 g of the cured product and 10 to 20 g (10 times the mass ratio of the cured product) of pure water are placed in a pressurized PTFE sealed container, extracted with hot water at a high temperature of 100 to 121°C for 10 to 20 hours, and the supernatant of the liquid extract is filtered through a membrane filter to obtain a sample solution. The pure water used here is distilled or ion-exchanged, and is used for reagent preparation, a test for trace analysis, and the like specified in JIS K 0557 (1998). For the procedure of the hot water pressurized extraction method, Yoshimi Hashimoto: Analytical Chemistry (Bunseki Kagaku), 49, 8 (2000), and for the extraction temperature condition, Ai Kitamura: Network Polymer, 33, 3 (2012) were referred to.

This sample solution is analyzed according to Japanese Industrial Standard JIS K 0127 (2013) Ion Chromatography General Rule Ion Chromatography. A standard solution of formate ions, acetate ions, propionate ions, and sulfate ions is introduced into an ion chromatography analyzer to create a calibration curve. Then, the concentration of each of formate ions, acetate ions, propionate ions, and sulfate ions is obtained from the peak area obtained by introducing 25 µL of the sample solution and the calibration curve, and a value obtained by converting the total of that concentrations into the mass of eluted ions relative to the mass of the organic film is defined as the ion elution amount.

In the hollow structure of the present invention, the ion elution amount when the organic film (I) as a hollow structure support material is evaluated by the ion elution amount evaluation method is preferably 2,000 ppm or less. When the content is 2,000 ppm or less, corrosion of metal wiring in the hollow structure under high temperature and high humidity conditions can be suppressed, and when the content is 1,000 ppm or less, it is more preferable from the viewpoint of corrosion suppression, and when the content is 500 ppm or less, it is still more preferable.

In the hollow structure of the present invention, the ion elution amount when the organic film (II) as a hollow structure roof material is evaluated by the ion elution amount evaluation method is preferably 2,000 ppm or less. When the content is 2,000 ppm or less, corrosion of metal wiring in the hollow structure under high temperature and high humidity conditions can be suppressed, and when the content is 1,000 ppm or less, it is more preferable from the viewpoint of corrosion suppression, and when the content is 500 ppm or less, it is still more preferable.

In the hollow structure of the present invention, the conductivity of the sample solution of the organic film (I) obtained by the ion elution amount evaluation method is preferably 500 µS/cm or less. When the conductivity of the sample solution is 500 µS/cm or less, the diffusion of acid ions under high temperature and high humidity conditions is reduced, so that corrosion of the metal wiring in the hollow structure can be suppressed. From the viewpoint of corrosion suppression, it is more preferable that the conductivity of the sample solution is 300 µS/cm or less.

In the hollow structure of the present invention, the conductivity of the sample solution of the organic film (II) obtained by the ion elution amount evaluation method is preferably 500 µS/cm or less. When the conductivity of the sample solution is 500 µS/cm or less, the diffusion of acid ions under high temperature and high humidity conditions is reduced, so that corrosion of the metal wiring in the hollow structure can be suppressed. From the viewpoint of corrosion suppression, it is more preferable that the conductivity of the sample solution is 300 µS/cm or less. The conductivity of the sample solution can be measured using the ion chromatography analyzer described in the ion elution amount evaluation method.

The organic film (I) and the organic film (II) have a film thickness of 5 to 30 um. Within the above range, it is possible to obtain an effect of corrosion suppression of metal wiring and a hollow structure sufficient for utilizing an elastic wave. The thickness is more preferably 10 to 20 um from the viewpoint of obtaining a sufficient hollow and workability.

As the organic film (I) and the organic film (II), a cured product obtained by curing a resin composition containing at least one resin selected from the group consisting of polyimide, polybenzoxazole or a precursor thereof, polyamidosiloxane, an epoxy resin, an acrylic resin, a novolac resin, a resole resin, polyhydroxystyrene, a modified product obtained by introducing a crosslinking group such as a methylol group, an alkoxymethyl group, or an epoxy group into them, and a copolymer thereof can be used.

The organic film (I) preferably contains a cured product obtained by curing a negative photosensitive resin composition containing at least one alkali-soluble resin (A) selected from the group consisting of polyimide, polybenzoxazole, polyamide, any of precursors thereof, and copolymers thereof, a thermally crosslinkable compound (C), an oxime-based photopolymerization initiator (D), and a polymerizable compound (E), wherein the oxime-based photopolymerization initiator (D) contains a compound represented by the formula (3).

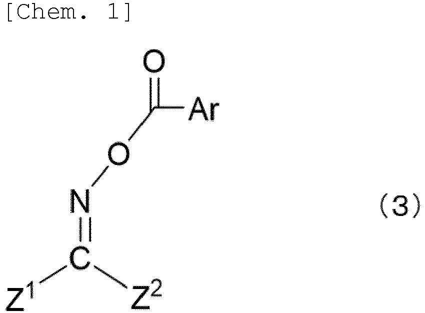

In the formula (3), Ar represents an aryl group, Z¹ represents an organic group having 6 to 20 carbon atoms, and Z² represents a hydrogen atom or an organic group having 1 to 20 carbon atoms.

When the negative photosensitive resin composition contains polyimide, polybenzoxazole, or polyamide, a hollow structure having high heat resistance, reliability against high temperature storage, thermal shock, and the like, and high mechanical strength can be obtained.

In the present invention, the term "alkali-soluble" means that the dissolution rate in an alkaline aqueous solution as a developing solution is 50 nm/min or more. Specifically, the term "alkali-soluble" means to have a dissolution rate determined in the following manner of 50 nm/min or more. A solution of a resin dissolved in γ-butyrolactone is applied to a silicon wafer, the resulting product is prebaked on the hot plate at 120°C for 4 minutes to form a prebaked film having a thickness of 10 um ± 0.5 um, the prebaked film is immersed in an alkaline aqueous solution selected from any one of a 2.38 mass% tetramethylammonium hydroxide aqueous solution at 23 ± 1°C for 1 minute, a 1 mass% potassium hydroxide aqueous solution, and a 1 mass% sodium hydroxide aqueous solution, and then subjected to a rinse treatment with pure water, and the dissolution rate is determined from the decrease in the film thickness.

The alkali-soluble resin (A) preferably has at least one repeating unit among repeating units represented below.

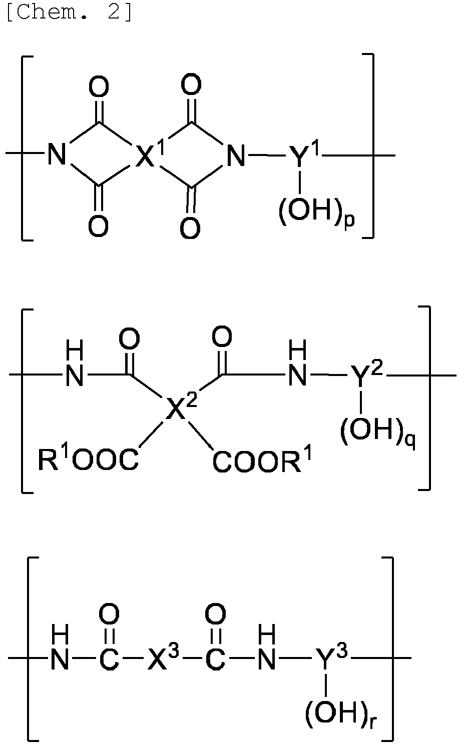

X¹ and X² in the repeating unit each represent an acid dianhydride residue, X³ represents a dicarboxylic acid residue, and Y¹(OH)ₚ and Y²(OH)_{q} and Y³(OH)ᵣ each represent a diamine residue. p and q and r each represent an integer in the range of 0 to 4, and R¹ represents a hydrogen atom or an organic group having 1 to 10 carbon atoms.

As the acid dianhydride and the diamine, known compounds can be used.

The main chain terminal of the alkali-soluble resin (A) may be sealed with a known monoamine, acid anhydride, monocarboxylic acid, a monoacid chloride compound, a monoactive ester compound, or the like can be used.

A cured product is easily obtained by heat treatment with the alkali-soluble resin (A) having a weight average molecular weight (Mw) of 3,000 or more in terms of polystyrene by gel permeation chromatography (GPC) in which a developing solvent contains 99.3 mass% of N-methyl-2-pyrrolidone, 0.2 mass% of lithium chloride, and 0.5 mass% of phosphoric acid, and in order to obtain a cured product having high extensibility and heat resistance, the weight average molecular weight is more preferably 10,000 or more, and still more preferably 20,000 or more. The alkali-soluble resin (A) having a weight average molecular weight of 200,000 or less can be processed as a photosensitive resin, and in order to obtain good pattern processability, the weight average molecular weight is more preferably 100,000 or less, and still more preferably 70,000 or less.

When the negative photosensitive resin composition contains the oxime-based photopolymerization initiator (D), a highly sensitive and high-resolution resin composition is obtained, and the width of the column material of the hollow structure can be reduced. The oxime-based photopolymerization initiator (D) contains a compound represented by formula (3). The compound represented by formula (3) has a small generation amount of low molecular acid ions due to decomposition, and can suppress metal wiring corrosion when formed into a cured product with high sensitivity.

Examples of the compound represented by formula (3) include 1,2-octanedione-1-[4-(phenylthio) phenyl]-2-(o-benzoyloxime), 1,2-propanedione-1-[4-(phenylthio) phenyl]-2-(o-benzoyloxime)-3-cyclopentane, "IRGACURE" (registered trademark) OXE-01 (Product name, manufactured by Ciba Japan K.K.), and PBG-305 (Product name, manufactured by CHANGZHOU TRONLY NEW ELECTRONIC MATERIALS CO., LTD).

Examples of the other oxime-based photopolymerization initiator (D) include 1-phenyl-1,2-butanedione-2-(o-methoxycarbonyl) oxime, 1-phenyl-1,2-propanedione-2-(o(methoxycarbonyl) oxime, 1-phenyl-1,2-propanedione-2-(o-ethoxycarbonyl) oxime, bis(α-isonitrosopropiophenone oxime) isophthal. "IRGACURE" (registered trademark) OXE-02, OXE-04 (Product name, manufactured by Ciba Japan K.K.), ADEKA ARKLS NCI-831, NCI-930 (Product name, manufactured by ADEKA Corporation), and the like.

In addition, as other photopolymerization initiators, the following photopolymerization initiators can be used as long as wiring corrosion due to acid ion generation is not deteriorated.

Examples of the photopolymerization initiator include benzophenones such as benzophenone, Michler's ketone, and 4,4,-bis(diethylamino)benzophenone, benzylidenes such as 3,5-bis(diethylaminobenzylidene)-N-methyl-4-piperidone, coumarins such as 7-diethylamino-3-thenoylcoumarin, anthraquinones such as 2-t-butylanthraquinone, benzoins such as benzoin methyl ether, mercaptos such as ethylene glycol di(3-mercaptopropionate), glycines such as N-phenylglycine, and α-aminoalkylphenones such as 2-benzyl-2-dimethylamino-1-(4-morpholinophenyl)-butane-1-2-methyl-1[4-(methylthio)phenyl]-2-morpholinopropan-1-one.

The content of the oxime-based Photopolymerization Initiator (D) is preferably 0.1 to 40 parts by mass, and more preferably 1 to 20 parts by mass based on 100 parts by mass of the total of the alkali-soluble resin (A). In addition, it is preferable to contain 70 to 100 mass% of the compound represented by formula (3) based on 100 mass% of the total amount of the oxime-based photopolymerization initiator (D). Within this range, good processability can be obtained, and an organic film in which the total elution amount of the acid ion content is 2,000 ppm or less can be obtained.

A negative photosensitive resin composition according to the present invention preferably contains at least one alkali-soluble resin (A) selected from the group consisting of polyimide, polybenzoxazole, polyamide, any of precursors thereof, and copolymers thereof, a thermally crosslinkable compound (C), an oxime-based photopolymerization initiator (D), and a polymerizable compound (E), wherein the content of the oxime-based photopolymerization initiator (D) is 1 to 20 parts by mass based on 100 parts by mass of the alkali-soluble resin (A), and the compound represented by formula (3) is contained in an amount of 70 to 100 mass% based on 100 mass% of the total amount of the oxime-based photopolymerization initiator (D). 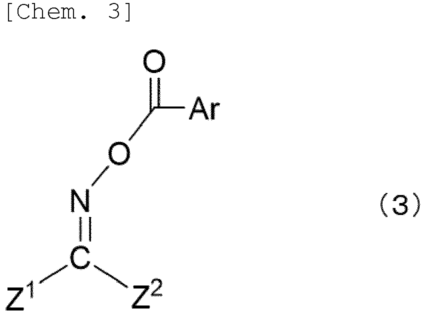 (In formula (3), Ar represents an aryl group, Z¹ represents an organic group having 6 to 20 carbon atoms, and Z² represents a hydrogen atom or an organic group having 1 to 20 carbon atoms.)

The thermally crosslinkable compound (C) refers to a compound having a crosslinkable group capable of bonding to a resin and the same kind of molecules other than a radically polymerizable group. Examples of the thermally crosslinkable compound (C) include a polyfunctional epoxy group-containing compound (C-1) and a polyfunctional alkoxymethyl group-containing compound (C-2). By containing the thermally crosslinkable compound (C), it is possible to obtain a hollow structure that undergoes a condensation reaction with a resin and the same type of molecules during heat treatment to form a crosslinked structure, has high chemical resistance, and is highly elastic and hardly flexible. In addition, reflow at the time of the heat treatment is less likely to occur, which contributes to the rectangularization of the hollow structure support material, so that the installation area with the roof member is expanded, and a hollow structure having a high adhesion force between the support material and the roof material can be obtained.

Examples of the polyfunctional epoxy group-containing compound (C-1) include, but are not limited to, alkylene glycol type epoxy resins such as a bisphenol A type epoxy resin, a bisphenol F type epoxy resin, and propylene glycol diglycidyl ether, polyalkylene glycol type epoxy resins such as polypropylene glycol diglycidyl ether, epoxy group-containing silicone such as polymethyl(glycidyloxypropyl)siloxane, and a novolak epoxy resin.

Specific examples thereof include TECHMORE VG3101L (Product name, manufactured by Printec Corporation) "TEPIC" (registered trademark) VL, "TEPIC" (registered trademark) UC (Product name, manufactured by Nissan Chemical Industries, Ltd.), "EPICLON" (registered trademark) 850-S, "EPICLON" (registered trademark) HP-4032, "EPICLON" (registered trademark) HP-7200, "EPICLON" (registered trademark) HP-820, "EPICLON" (registered trademark) HP-4700, "EPICLON" (registered trademark) EXA-4710, "EPICLON" (registered trademark) HP-4770, "EPICLON" (registered trademark) EXA-859 CRP, "EPICLON" (registered trademark) EXA-1514, "EPICLON" (registered trademark) EXA-4880, "EPICLON" (registered trademark) EXA-4850-150, "EPICLON" (registered trademark) EXA-4850-1000, "EPICLON" (registered trademark) EXA-4816, and "EPICLON" (registered trademark) EXA-4822 (which are all Product names, manufactured by DIC Corporation.), RIKA resin (registered trademark) BEO-60E (Product name, New Japan Chemical Co., Ltd.), EP-4003S, and EP-4000S (which are all Product names, manufactured by ADEKA CORPORATION.), and JER 157s 70 (Product name, manufactured by Mitsubishi Chemical Corporation).

Specific examples of the polyfunctional alkoxymethyl group-containing compound (C-2) include, as having two functional groups, DM-BI25X-F, 46DMOC, 46DMOIPP, and 46DMOEP (which are all Product names, manufactured by Asahi Organic Chemical Industry Co., Ltd.), DML-MBPC, DML-MBOC, DML-OCHP, DML-PC, DML-PCHP, DML-PTBP, DML-34X, DML-EP, DML-POP, DML-OC, dimethylol-Bis-C, dimethylol-BisOC-P, DML-BisOC-Z, DML-BisOCHP-Z, DML-PFP, DML-PSBP, DML-MB25, DML-MTrisPC, DML-Bis25X-34XL, and DML-Bis25X-PCHP (which are all Product names, manufactured by Honshu Chemical Industry Co., Ltd.), "NIKALAC" (registered trademark) MX-290 (Product name, manufactured by Sanwa Chemical Co., Ltd.), B-a type benzoxazine, and B-m type benzoxazine (which are all Product names, manufactured by Shikoku Chemicals Corporation.), 2,6-dimethoxymethyl-4-t-butylphenol, 2,6-dimethoxymethyl-p-cresol, and 2,6-diacetoxymethyl-p-cresol, as having three functional groups, TriML-P, TriML-35XL, and TriML-TrisCR-HAP (which are all Product names, manufactured by Honshu Chemical Industry Co., Ltd.), as having four functional groups, TM-BIP-A (Product name, manufactured by Asahi Organic Chemical Industry Co., Ltd.), TML-BP, TML-HQ, TML-pp-BPF, TML-BPA, and TMOM-BP (which are all Product names, manufactured by Honshu Chemical Industry Co., Ltd.), "NIKALAC" (registered trademark) MX 280, and "NIKALAC" (registered trademark) MX 270 (which are all Product names, manufactured by Asahi Organic Chemical Industry Co., Ltd.), and as having six functional groups, HML-TPPHBA, HML-TPHAP, HMOM-TPPHBA, and HMOM-TPHAP (which are all Product names, manufactured by Honshu Chemical Industry Co., Ltd.), and "NIKALAC" (registered trademark) MW-390 and "NIKALAC" (registered trademark) MW-100 LM (which are all Product names, manufactured by Sanwa Chemical Co., Ltd.).

The polyfunctional epoxy group-containing compound (C-1) can obtain chemical resistance while reducing the organic acid, but tends to decrease alkali solubility. On the other hand, the polyfunctional alkoxymethyl group-containing compound (C-2) can obtain high chemical resistance, but tends to contain formate ions and the like as impurities. Therefore, it is preferable to contain these compounds in an appropriate amount.

The content of the thermally crosslinkable compound (C) is preferably 1 to 40 parts by mass, more preferably 10 to 30 parts by mass based on 100 parts by mass of the alkali-soluble resin (A). By setting the content of the thermally crosslinkable compound (C) within this range, it is possible to obtain a hollow structure in which the total elution amount of the acid ion content is 2,000 ppm or less, and it is possible to obtain a hollow structure having high chemical resistance, high elasticity, a high rectangle, and a high adhesion force between the support material and the roof material.

In addition, the content of the polyfunctional epoxy group-containing compound (C-1) is preferably 5 to 30 parts by mass and the content of the polyfunctional alkoxymethyl group-containing compound (C-2) is preferably 1 to 10 parts by mass based on 100 parts by mass of the alkali-soluble resin (A).

By setting the content of the thermally crosslinkable compound (C) within this range, it is possible to obtain a hollow structure having high chemical resistance, a high rectangular shape, and a high adhesion force between the support material and the roof material while suppressing the acid ion content.

The polymerizable compound (E) refers to a compound having one or more radical polymerizable functional groups in the molecule.

Specific examples of the polymerizable compound (E) include, but are not limited to, ethylene glycol diacrylate, ethylene glycol dimethacrylate, diethylene glycol diacrylate, diethylene glycol dimethacrylate, triethylene glycol diacrylate, triethylene glycol dimethacrylate, tetraethylene glycol diacrylate, tetraethylene glycol dimethacrylate, trimethylolpropane diacrylate, trimethylolpropane triacrylate, trimethylolpropane dimethacrylate, trimethylolpropane trimethacrylate, 1,3-butanediol diacrylate, 1,3-butanediol dimethacrylate, neopentyl glycol diacrylate, 1,4-butanediol diacrylate, 1,4-butanediol dimethacrylate, 1,6-hexanediol diacrylate, 1,6-hexanediol dimethacrylate, 1,9-nonanediol dimethacrylate, isocyanuric acid ethylene oxide-modified triacrylates such as 1,10-decanediol dimethacrylate, dimethylol-tricyclodecane diacrylate, pentaerythritol triacrylate, pentaerythritol trimethacrylate, pentaerythritol tetraacrylate, pentaerythritol tetramethacrylate, dipentaerythritol hexaacrylate, dipentaerythritol hexamethacrylate, 1,3-diacryloyloxy-2 hydroxypropane, 1,3-dimethacryloyloxy-2-hydroxypropane, N,N-methylene bisacrylamide, BP-6EM, DCP-A (Product name, manufactured by Kyoeisha Chemical Co., Ltd.), AH-600 (Product name, manufactured by Kyoeisha Chemical Co., Ltd.), AT-600 (Product name, manufactured by Kyoeisha Chemical Co., Ltd.), UA-306H (Product name, manufactured by Kyoeisha Chemical Co., Ltd.), UA-306T (Product name, manufactured by Kyoeisha Chemical Co., Ltd.), ethylene oxide-modified bisphenol A diacrylate, ethylene oxide-modified bisphenol A dimethacrylate, isocyanuric acid ethylene oxide-modified diacrylate, and isocyanuric acid ethylene oxide modified triacrylate "Aronix" (registered trademark) M-315 (Product name, manufactured by Toagosei Co., Ltd.). These can be contained alone or in combination of two or more thereof.

The polymerizable compound (E) preferably contains a compound represented by formula (4).

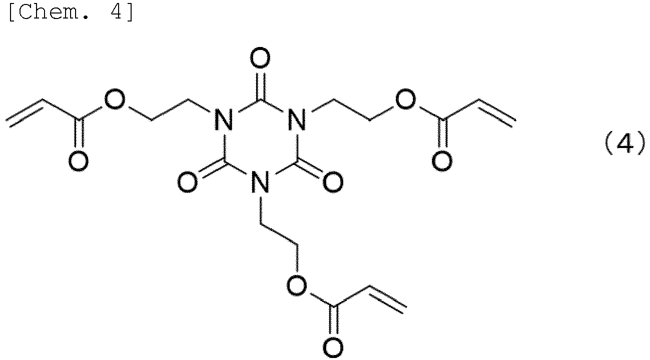

By containing the compound represented by formula (4), good patternability and heat resistance are obtained, so that the width of the hollow structure support material can be reduced, and a cured product having high heat resistance is obtained.

The content of the polymerizable compound (E) is preferably 5 to 200 parts by mass, and, from the viewpoint of compatibility, more preferably 5 to 150 parts by mass based on 100 parts by mass of the alkali-soluble resin (A). By setting the content of the polymerizable compound (E) to 5 parts by mass or more, elution of the exposed portion during development can be prevented, and a resin composition having a high residual film rate after development can be obtained. By setting the content of the polymerizable compound (E) to 200 parts by mass or less, film whitening during film-formation can be suppressed.

The compound represented by formula (4) is preferably contained in an amount of 55 to 90 mass% based on 100 mass% of the total amount of the polymerizable compound (E). When the content is 55 mass% or more, high resolution and heat resistance can be obtained, and when the content is 90 mass% or less, flexibility of a cured product can be maintained and high mechanical strength can be obtained.

The polymerizable compound (E) can be contained alone or in combination of two or more thereof.

As the photosensitive resin composition for obtaining the organic film (I), in addition to the negative photosensitive resin composition described above, a negative photosensitive resin composition using a photo acid generator as a cationic polymerization initiator and an epoxy compound, an oxetane compound, or an epoxy resin as a cationic polymerizable compound, or a positive photosensitive resin composition using a naphthoquinone diazide compound as a photo acid generator can also be used as long as the ion elution amount of the organic film is not increased.

The organic film (I) preferably contains a cured product obtained by curing a positive photosensitive resin composition containing at least one alkali-soluble resin (A) selected from the group consisting of polyimide, polybenzoxazole, polyamide, any of precursors thereof, and copolymers thereof, a naphthoquinone diazide compound (B), and a thermally crosslinkable compound (C).

Examples of the naphthoquinone diazide compound (B) include a polyhydroxy compound to which a sulfonic acid group of a quinonediazide is ester-bonded, a polyamino compound to which a sulfonic acid group of a quinonediazide is sulfonamide-bonded, a polyhydroxypolyamino compound to which a sulfonic acid group of a quinonediazide is ester-bonded and/or sulfonamide-bonded. Not all the functional groups of these polyhydroxy compounds, polyamino compounds, and polyhydroxypolyamino compounds are required to be substituted with quinonediazide, and it is preferable that 40 mol% or more of all the functional groups on average be substituted with quinonediazide. Because of containing such a quinonediazide compound, it is possible to obtain a positive photosensitive resin composition that is sensitive to i-line (wavelength: 365 nm), h-line (wavelength: 405 nm), and g-line (wavelength: 436 nm) from a mercury lamp that are general ultraviolet rays.

The naphthoquinone diazide compound (B) preferably contains a compound represented by formula (1) and/or formula (2).

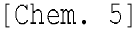

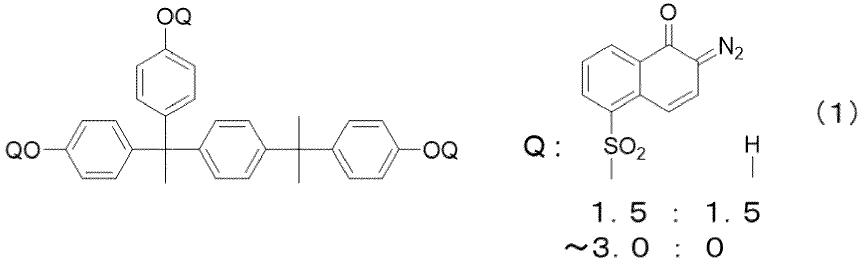

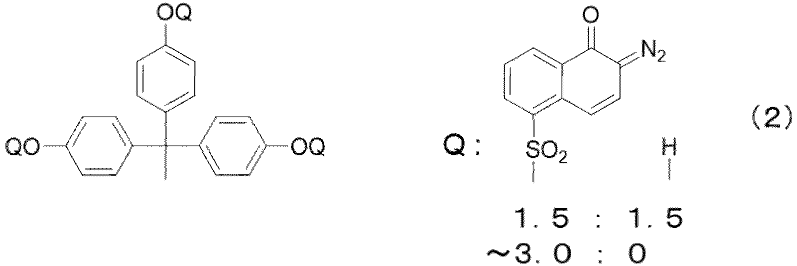

Since the compounds represented by the formula (1) and the formula (2) are stable to heat, generation of sulfate ions during the heat treatment is suppressed, and a hollow structure having a small acid ion content can be obtained.

The content of the naphthoquinone diazide compound (B) is preferably 1 to 30 parts by mass, more preferably 10 to 20 parts by mass based on 100 parts by mass of the alkali-soluble resin (A). By setting the content of the quinone diazide compound within this range, a hollow structure having a total elution amount of the acid ion content of 2,000 ppm or less can be obtained, and high resolution can be obtained, so that the width of the hollow structure support material can be reduced. Reducing the width of the hollow structure support material is important to reduce the overall MEMS package while maintaining the hollow space of the hollow structure.

In addition, the positive type or negative photosensitive resin composition may contain a surfactant or an adhesion improver, whereby wettability and adhesion to a substrate can be improved.

In the hollow structure of the present invention, the photosensitive resin composition for obtaining the organic film (I) is preferably in the form of a liquid or a sheet. It is preferable that the positive-type or the negative photosensitive resin composition of the present invention further contain a solvent. Examples of the solvent include aprotic polar solvents such as N-methyl-2-pyrrolidone, γ-butyrolactone, γ-valerolactone, δ-valerolactone, N,N-dimethylformamide, N,N-dimethylacetamide, dimethyl sulfoxide, 1,3-dimethyl-2-imidazolidinone, N,N'-dimethylpropyleneurea, N,N-dimethylisobutyramide, N,N-dimethylpropanamide, 3-methoxy-N,N-dimethylpropanamide, and N,N-dimethyllactamide, and aromatic hydrocarbons. Two or more of these solvents may be contained.

The content of the solvent is preferably 100 to 1,500 parts by mass based on 100 parts by mass of the alkali-soluble resin (A), and when the content is in this range, a cured product having a film thickness of 5 to 30 um can be formed as the organic film (I).

A highly elastic hollow structure can be obtained in such a manner that the organic film (I) contains 30 to 80 mass% of inorganic particles in 100 mass% of the organic film (I), and the organic film (II) contains 0 to 80 mass% of inorganic particles in 100 mass% of the organic film (II); or the organic film (II) contains 30 to 80 mass% of inorganic particles in 100 mass% of the organic film (II), and the organic film (I) contains 0 to 80 mass% of inorganic particles in 100 mass% of the organic film (I). By making the hollow structure highly elastic, it is possible to obtain a hollow structure that is hardly bent.

The organic film (I) has high elasticity by containing 30 to 80 mass% of inorganic particles in 100 mass% of the organic film (I). In this case, the organic film (II) also preferably contains 30 to 80 mass% of inorganic particles in 100 mass% of the organic film (II), and may contain less than 30 mass%. However, it is not preferable that the organic film (II) contains inorganic particles in an amount exceeding 80 mass% from the viewpoint of processability. Similarly, the organic film (II) has high elasticity by containing 30 to 80 mass% of inorganic particles in 100 mass% of the organic film (II). In this case, the organic film (I) also preferably contains 30 to 80 mass% of inorganic particles in 100 mass% of the organic film (I), and may contain less than 30 mass%. However, it is not preferable that the organic film (I) contains inorganic particles in an amount exceeding 80 mass% from the viewpoint of processability.

When the content of the inorganic particles is within the above range, good processability can be obtained as a photosensitive resin composition and a high elastic modulus can be obtained as a cured product.

As the inorganic particles, glass particles are preferable from the viewpoint of the processability of the photosensitive resin composition for obtaining an organic film. Glass in the present invention refers to glass having no sharp peak (half-value width of 2° or less) representing a crystal structure of a specific component in powder X-ray analysis measurement of 2θ-θ.

The glass particles preferably contain at least two selected from the group consisting of silicon oxide, aluminum oxide, and boron oxide, and the glass particles preferably further contains a rare earth oxide. The rare earth oxide is preferably yttrium oxide or lanthanoid oxide.

The refractive index of the glass particles is preferably 1.55 to 1.75. The refractive index can be measured by a V block method. In the present invention, the result of measurement at a wavelength of 405 nm is taken as the refractive index. When the refractive index is set to 1.55 to 1.75, scattering and reflection hardly occur during exposure when processing a photosensitive resin composition for obtaining an organic film, and good pattern processability can be obtained.

The average particle size of inorganic particles to be used in the present invention is preferably 0.1 um to 3.0 um. Within this range, good processability can be obtained as a photosensitive resin composition and a high elastic modulus can be obtained as a cured product.

In the hollow structure of the present invention, the photosensitive resin composition for obtaining the organic film (II) is preferably in the form of a sheet. By using the sheet-like photosensitive resin composition as a roof material, a hollow structure can be formed. The photosensitive resin composition is applied onto a support film, and then dried to obtain a photosensitive sheet having a photosensitive layer on the support film.

Next, an example of a method for forming a hollow structure of the present invention will be described with reference to the drawings.

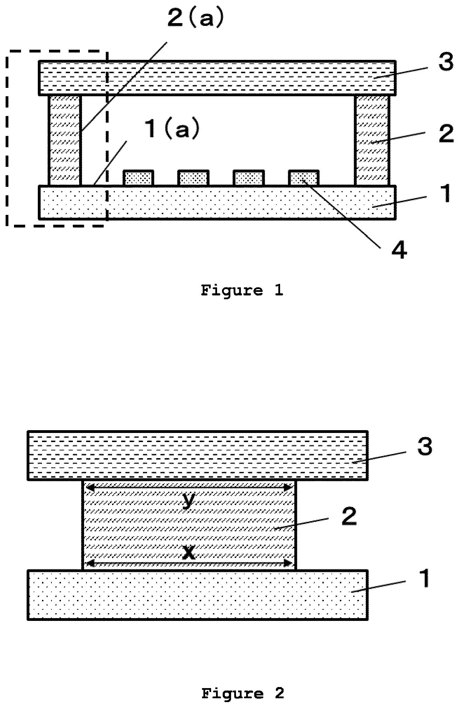

Fig. 1 illustrates a cross-sectional view of a hollow structure according to the present invention.
First, a photosensitive resin composition for forming an organic film (I) 2 is applied onto a substrate 1 having a metal wiring 4. As the substrate 1, silicon, silicon oxide, lithium tantalate, lithium niobate, gallium arsenide or the like on which aluminum wiring or copper wiring is formed is mainly used, but the substrate is not limited thereto. The thickness of the metal wiring 4 is preferably 0.1 to 5 µm.

Examples of the method for applying the photosensitive resin composition to be used for the organic film (I) include methods such as spin coating using a spinner, spray coating, roll coating, screen printing, blade coater, die coater, calender coater, meniscus coater, bar coater, roll coater, comma roll coater, gravure coater, screen coater, and slit die coater. The coating thickness film is usually formed so that the thickness of the dried film is 5 to 30 um although the thickness depends on the coating technique, the solid content concentration of the composition, the viscosity, and the like. The solid content concentration of the composition is preferably 50 to 70%, and the viscosity is preferably 500 to 5,000 cP. Within this range, the coating film thickness can be formed.

In the case that the photosensitive resin composition used in the organic film (I) is used as a photosensitive sheet, the photosensitive resin composition is applied to a base material, and the organic solvent is removed to produce a photosensitive sheet.
A PET film or the like can be used as a substrate to which the photosensitive resin composition is applied. When the PET film as a base material needs to be peeled off in the case of use of the photosensitive sheet attached to a substrate such as a silicon wafer, a PET film whose surface is coated with a release agent such as a silicone resin is preferably used to easily peel the PET film off the photosensitive sheet.

As a method of applying the photosensitive resin composition to a PET film, screen printing or a method in which a spray coater, a bar coater, a blade coater, a die coater, a spin coater, or the like is used can be used. Examples of the method of removing the organic solvent include heating with an oven or a hot plate, vacuum drying, and heating with electromagnetic waves such as infrared rays and microwaves. If the organic solvent is insufficiently removed, there is a possibility that a cured product obtained by subsequent curing treatment will be uncured or have a poor thermomechanical property. The thickness of the PET film is not particularly limited, and is preferably in the range of 30 to 80 um from the viewpoint of workability. In order to protect the surface of the photosensitive sheet from dust and the like in the atmosphere, a cover film may be attached to the surface of the photosensitive sheet. If a photosensitive sheet having a desired film thickness cannot be prepared because of the low solid content concentration of the photosensitive resin composition, two or more photosensitive sheets may be attached to each other after removal of the organic solvent.

When the photosensitive sheet produced by the above-described method is attached to another substrate, the photosensitive sheet may be attached using a laminating device such as a roll laminator or a vacuum laminator, or may be manually attached, using a rubber roller, to a substrate heated on a hot plate. After the attachment to the substrate, the resulting product is sufficiently cooled, and then the PET film is peeled off.

It is also possible to pretreat the substrate with the above-mentioned silane coupling agent in order to improve the adhesion properties between the substrate and the photosensitive resin composition. For example, the surface of the substrate is treated with a solution prepared by dissolving 0.5 to 20 mass% of the silane coupling agent in a solvent such as isopropanol, ethanol, methanol, water, tetrahydrofuran, propylene glycol monomethyl ether acetate, propylene glycol monomethyl ether, ethyl lactate, or diethyl adipate by spin coating, dipping, spray coating, steam treatment, or the like. In some cases, heat treatment is then performed at 50°C to 300°C to promote the reaction between the substrate and the silane coupling agent. Next, the photosensitive resin composition is applied to the substrate, or the substrate laminated with the photosensitive sheet is dried to obtain a photosensitive resin composition film. The drying is preferably performed using an oven, a hot plate, infrared rays, or the like in the range of 50°C to 150°C for 1 minute to several hours.

Next, the photosensitive resin composition film is irradiated with and exposed to an actinic ray through a mask having a desired pattern. Examples of the actinic ray to be employed for the exposure to light include ultraviolet ray, visible light, electron beam and X-ray.
In the present invention, i-line (365 nm), h-line (405 nm) or g-line (436 nm) of a mercury lamp can be used preferably. In the case of the negative type, in order to allow the reaction by exposure to proceed to the substrate surface, it is preferable to perform heating at 50°C to 150°C for 1 minute to 1 hour using a hot plate after the exposure.

In order to form a pattern, after the exposure, the exposed portion is removed in the case of the positive photosensitive resin composition, and the unexposed portion is removed in the case of the negative photosensitive resin composition using a developing solution. As the developing solution, a solution of an alkaline compound such as tetramethylammonium hydroxide, diethanolamine, diethylaminoethanol, sodium hydroxide, potassium hydroxide, sodium carbonate, potassium carbonate, triethylamine, diethylamine, methylamine, dimethylamine, dimethylaminoethyl acetate, dimethylaminoethanol, dimethylaminoethyl methacrylate, cyclohexylamine, ethylenediamine, or hexamethylenediamine is preferable.

In some cases, to the alkaline solution, a polar solvent such as N-methyl-2-pyrrolidone, N,N-dimethylformamide, N,N-dimethylacetamide, dimethylsulfoxide, γ-butyrolactone, or dimethylacrylamide, an alcohol such as glycerin, methanol, ethanol, or isopropanol, an ester such as ethyl lactate or propylene glycol monomethyl ether acetate, a ketone such as cyclopentanone, cyclohexanone, isobutyl ketone, or methyl isobutyl ketone, or the like may be added singly or in combination of several kinds thereof.

In some cases, an organic solvent such as a ketone-based solvent, an ester-based solvent, an alcohol-based solvent, a nitrile-based solvent, an amide-based solvent, or an ether-based solvent can also be used as the developing solution. The development can be performed by a method of spraying the above-described developing solution on the film face, immersing in the developing solution, applying ultrasonic waves during immersing, spraying the developing solution on the rotating substrate, or the like. After the development, a rinse treatment is preferably performed with water. Here, alcohols such as ethanol and isopropyl alcohol, esters such as ethyl lactate and propylene glycol monomethyl ether acetate, or the like may be added to the water for the rinsing treatment.

After the development, a temperature of 150°C to 500°C is added to promote volatilization of the solvent, a ring-closing reaction of the resin, and a crosslinking reaction of the thermally crosslinkable compound. The term "cured product" in the present invention refers to a resin composition subjected to the heat treatment. As a method for the heat treatment, a method for selecting a temperature and raising the temperature stepwise or a method for selecting a certain temperature range and performing the heat treatment for 5 minutes to 5 hours while continuously raising the temperature can be selected. An example of the former includes a method in which the heat treatment is performed at 130°C and 200°C for 30 minutes each. An example of the latter includes a method for linearly raising the temperature from room temperature to 400°C over 2 hours. The heat treatment temperature in the present invention is preferably 150 to 350°C, and more preferably 170 to 300°C from the viewpoint of reducing damage to the substrate and obtaining good organic film characteristics.

As illustrated in Fig. 1, the organic film (I) 2 is formed on the substrate 1, and then an organic film (II) 3 is formed using a photosensitive sheet material. The method for forming the organic film (II) 3 can be the same method as the above method for forming the organic film (I) from a photosensitive sheet.

Fig. 2 illustrates a cross section of the organic film (I) cut in a direction perpendicular to the wall surfaces of the substrate 1 and the organic film (I) 2. Fig. 2 is an enlarged view of a portion surrounded by a broken line in Fig. 1. In a cross section perpendicular to the upper surface of the substrate and the wall surface of the organic film (I), when a length of a ground contact surface between the organic film (I) and the substrate is set as x and a length of a ground contact surface between the organic film (I) and the organic film (II) is set as y, 1 ≥ y/x ≥ 0.6 is preferably satisfied. By satisfying the above range, even when the width of the hollow structure support material is reduced, it is possible to secure an adhesion area of the roof material with the organic film (II) and to obtain a hollow structure in which peeling hardly occurs. x is preferably in the range of 5 to 100 µm, more preferably in the range of 10 to 50 µm, and still more preferably in the range of 10 to 30 um from the viewpoint of securing sufficient adhesion between the hollow space and the roof material.

The electronic component of the present invention is an electronic component having the hollow structure of the present invention such as MEMS.

### EXAMPLES

The present invention will be illustrated below with reference to Examples, but it should be understood that the present invention is not construed as being limited thereto.
First, the evaluation method in each Example and Comparative Example will be described.

### (1) Method for creating substrate

A Ti sputtered film in which titanium (Ti) was layered in a thickness of 100 nm on a silicon substrate by sputtering was prepared. Copper was layered in a thickness of 250 nm on a Ti sputtered film by sputtering. After sputtering, a copper plated film having a thickness of 5 um was formed by electrolytic plating.

### (2) Formation of hollow structure

A photosensitive varnish was applied onto the substrate using a spin coater, and baked at 120°C for 3 minutes using a hot plate to obtain a prebaked film having a thickness of 10 to 13 um. Next, exposure was performed at 500 to 1,000 mJ/cm² using a ghi aligner using a mask having a grid-like pattern with a width of 30 um and intervals of 200 um. After the exposure, the film was developed with a 2.38 mass% aqueous tetramethylammonium (TMAH) solution for 100 to 200 seconds, and then rinsed with pure water to obtain a developed film having a grid-like remaining pattern with a film thickness of 10 µm, a width of 30 µm, and an interval of 200 um. The developed film was heated to 200°C at an oxygen concentration of 20 ppm or less at a temperature rising rate of 3.5°C per minute under a nitrogen stream using an inert oven, and subjected to a heat treatment at 200°C for 1 hour to form a hollow structure support material having a thickness of 10 um by the organic film (I).
Next, a photosensitive sheet having a thickness of 20 to 23 um was used as the organic film (II) using a laminator (VTM-200M manufactured by Takatori Corporation) under the conditions of a stage temperature of 80°C, a roll temperature of 80°C, a degree of vacuum of 150 Pa, an attachment speed of 5 mm/sec, and an attachment pressure of 0.2 MPa. After exposure at 500 to 1,000 mJ/cm² using a ghi aligner, the developed film was heated to 200°C at an oxygen concentration of 20 ppm or less at a temperature rising rate of 3.5°C per minute under a nitrogen stream using an inert oven, and subjected to a heat treatment at 200°C for 1 hour to form a hollow structure roof material having a thickness of 20 um by the organic film (II), thereby obtaining a hollow structure.

### (3) Evaluation of corrosion resistance of hollow structure

Using a highly accelerated life test apparatus (saturated pressure cooker test apparatus), the hollow structure created in section (2) was stored under conditions of 121°C, a humidity of 100%, and 2 atmospheres for 100 hours, and then the hollow portion was cut using a dicing apparatus. A copper plated cross section of the substrate was polished with a cross section polisher (IB-09010CP manufactured by JEOL Ltd.), and then observed using a scanning electron microscope (S-4800 manufactured by Hitachi, Ltd.). The thickness of copper oxide formed on the copper plating was measured, and the copper oxide having a thickness of 150 nm or less was designated as A, the copper oxide having a thickness of more than 150 nm and 200 nm or less was designated as B, and the copper oxide having a thickness of more than 200 nm was designated as C.

### (4) Evaluation of adhesion between hollow structure support material and roof material

Using the hollow structure created in (2), the presence or absence of peeling was observed with an optical microscope. A sample was rated A when there was no peeling or bubble between the organic film (I) and the organic film (II), a sample was rated B when there was no peeling and bubble, and a sample was rated C when there was peeling.

### (5) Evaluation of acid ion elution amount and conductivity

### (5-1) Evaluation of acid ion elution amount and conductivity of organic film (I)

First, a cured product of the organic film (I) was created by the following method.

The photosensitive varnish was applied onto a PET film having a thickness of 38 um using a comma roll coater, and the resultant was dried at 80°C for 8 minutes, and then layered with a PP film having a thickness of 10 um as a protective film to obtain a photosensitive sheet. The film thickness of the photosensitive sheet was prepared to 30 µm.

This photosensitive sheet was bonded to a PTFE film heated on a hot plate at 120°C using a rubber roller, then the PET film was peeled off, and the photosensitive sheet on the PTFE film was heated to 200°C at a temperature rising rate of 3.5°C per minute at an oxygen concentration of 20 ppm or less under a nitrogen stream using an inert oven, and subjected to a heat treatment at 200°C for 1 hour to obtain a cured product.

Next, the cured product peeled off from the PTFE film was freeze-pulverized using liquid nitrogen, 2.0 g of the product was weighed and put together with 20 g of pure water in a PTFE closed pressure-resistant decomposition container, and stored for 20 hours under the conditions of 121°C, a humidity of 100%, and 2 atmospheres using a highly accelerated life test apparatus (saturated pressure cooker test apparatus). The supernatant of the liquid extract was filtered through a membrane filter having a pore size of 0.45 um to obtain a sample solution.

Next, in accordance with the ion chromatography general ion chromatography method of Japanese Industrial Standard JIS K 0127 (2013), standard solutions of formate ions, acetate ions, propionate ions, and sulfate ions were introduced into an ion chromatography analyzer (ICS-3000 manufactured by Dionex Corporation), and a calibration curve was created. 25 µL of the sample solution was introduced, the concentrations of formate ions, acetate ions, propionate ions, and sulfate ions in the sample solution were determined from the obtained peak and calibration curve, and the total amount of eluted ion mass was determined. A sample having an ion elution amount of 500 ppm or less, obtained as an eluted ion mass with respect to the mass of the organic film, was rated A, a sample having an ion elution amount of more than 500 ppm and 2,000 ppm or less was rated B, and a sample having an ion elution amount of more than 2,000 ppm was rated C. A sample in which the conductivity of the sample solution measured by the ion chromatography analyzer was 300 µS/cm or less was rated as A, a sample in which the conductivity was more than 300 µS/cm and 500 µS/cm or less was rated as B, and a sample in which the conductivity was more than 500 µS/cm was rated as C.

### (5-2) Evaluation of acid ion elution amount and conductivity of organic film (II)

Using the photosensitive sheet, a cured product of the organic film (II) was created in the same manner as in (5-1), and the total amount of eluted ions and the conductivity of the sample solution were determined.

### (5-3) Total of acid ion elution amounts of organic film (I) and organic film (II)

The total ion elution amount obtained in (5-1) and (5-2) was determined. A sample having a total of 1,000 ppm or less was designated as A, a sample having a total of more than 1,000 ppm and 4,000 ppm or less was designated as B, and a sample having a total of more than 4,000 ppm was designated as C.

### (6) Evaluation of cross-sectional shape of organic film (I)

The hollow structure formed in (2) was cut by a dicing apparatus, a cross section of the lattice pattern of the organic film (I) in the lateral direction was observed using a scanning electron microscope (S-4800 manufactured by Hitachi, Ltd.), and the length was measured. When the length of the ground contact surface between the substrate 1 and the organic film (I) was set as x and the length of the ground contact surface between the organic film (II) and the organic film (I) was set as y, a case where 1 ≥ y/x ≥ 0.8 was set as A, a case where 0.8 > y/x ≥ 0.6 was set as B, and a case where 0.6 > y/x was set as C.

### (7) Evaluation of weight loss temperature of organic film (I)

15 mg of the cured product peeled off from the PTFE film in (5-1) was weighed, and the temperature was raised from 25°C to 400°C at a temperature raising rate of 10°C/min using a thermogravimetric analyzer (TGA-50 manufactured by Shimadzu Corporation) to evaluate the heat resistance. A sample having a temperature of 350°C or higher when 5% of the weight decreased from the weight before the temperature rise was set as A, a sample having a temperature of less than 350°C and 300°C or higher was set as B, and a sample having a temperature of less than 300°C was set as C.

### (8) Evaluation of elastic modulus of organic film (I)

The cured product peeled off from the PTFE film in (5-1) was cut into a strip shape of 10 mm × 5 mm, the temperature was raised from 25°C to 400°C under the conditions of a frequency of 1 Hz and a temperature raising rate of 10°C/min, and the storage elastic modulus at 50°C was measured using a dynamic viscoelasticity measuring device (DMS 6100 manufactured by Shimadzu Corporation).

### (9) Evaluation of elastic modulus of organic film (II)

Using the photosensitive sheet, a cured product of the organic film (II) was created in the same manner as in (5-1), and the cured product peeled off from the PTFE film was cut into a strip shape of 10 mm × 5 mm, and the storage elastic modulus was measured in the same manner as in (8).

### (10) Evaluation of sealing ratio of hollow structure

Among the hollow structures of 100 squares formed in a lattice shape on the substrate in (2), squares in which the hollow structure roof material formed a hollow without being in contact with the substrate were counted, and the ratio was calculated as a normal rate. A sample having 90% or more was rated as A, and a sample having less than 90% and 80% or more was rated as B.

Names and structures of abbreviations of compounds used in the following Examples and Comparative Examples are as follows.

### (Acid dianhydride)

ODPA: 3,3', 4,4'-diphenylethertetracarboxylic acid dianhydride

### (Diamine)

BAHF: 2,2-bis(3-amino-4-hydroxyphenyl)hexafluoropropane RT-1000: Jeffamine RT-1000 (Product name, manufactured by HUNTSMAN Corporation)
SiDA: 1,1,3,3-tetramethyl-1,3-bis(3-aminopropyl)disiloxane

### (End capping agent)

MAP: 3-aminophenol
NA: 5-norbornene-2,3-dicarboxylic acid

### (Solvent)

NMP: N-methyl-2-pyrrolidone
GBL: γ-butyrolactone
EL: Ethyl lactate

### (Thermally crosslinkable compound)

HMOM-TPHAP (Product name, manufactured by Honshu Chemical Industry Co., Ltd.) Polyfunctional alkoxymethyl group-containing compound
VG-3101 L (TECHMORE VG 3101 L, Product name, manufactured by Printec Corporation) Polyfunctional epoxy group-containing compound
MW-100 LM (NIKALAC MW-100 LM, Product name, manufactured by Sanwa Chemical Co., Ltd.) Polyfunctional alkoxymethyl group-containing compound
TEPIC-VL (Product name, manufactured by Nissan Chemical Corporation).
JER 157s 70 (Product name, manufactured by Mitsubishi Chemical Corporation)

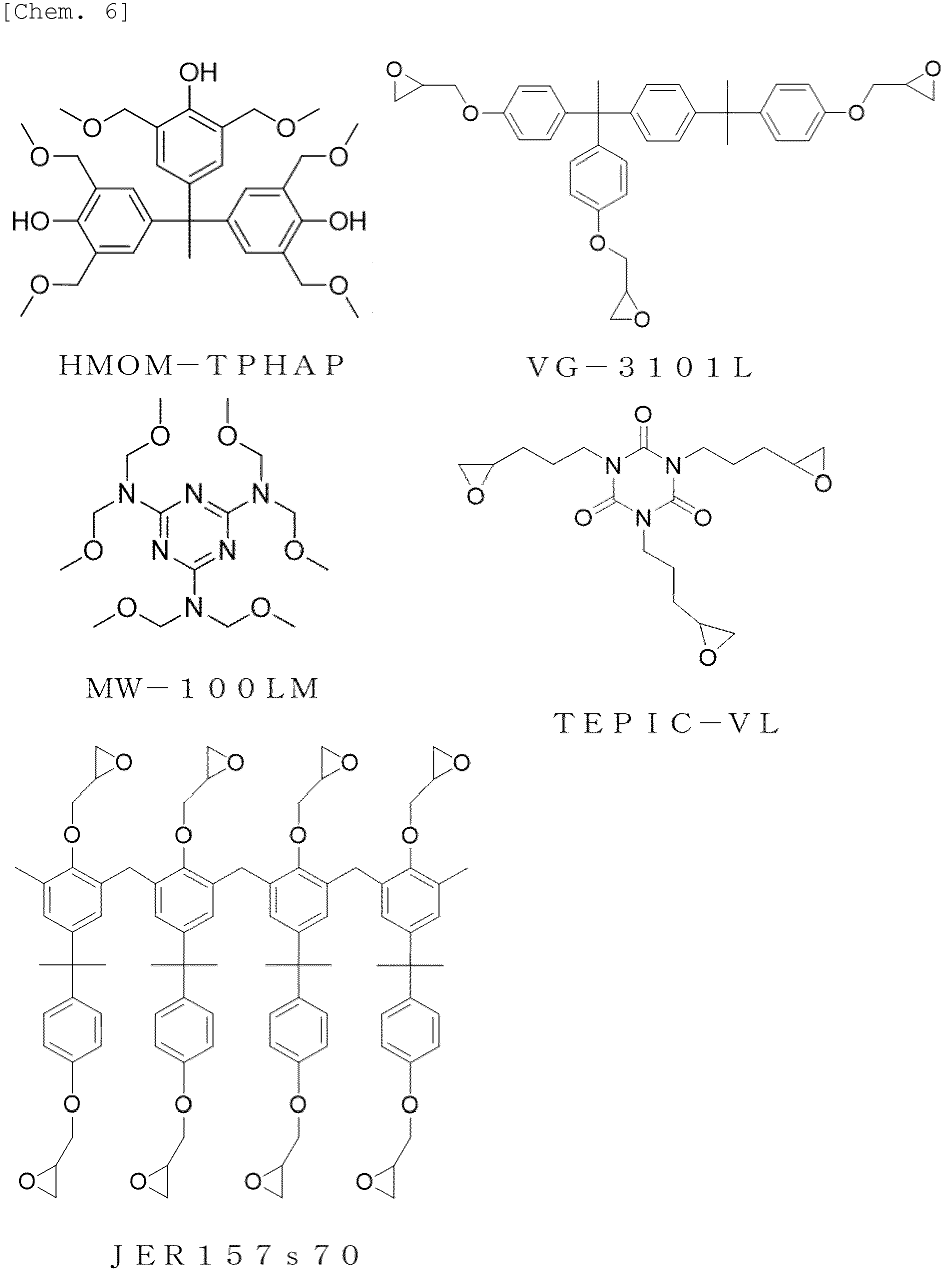

### (Adhesion improver)

KBM-403 (Product name, manufactured by Shin-Etsu Chemical Co., Ltd.) 3-glycidoxypropyltriethoxysilane

### (Surfactant)

PF77: Polyflow 77 (Product name, manufactured by Kyoeisha Chemical Co., Ltd.) Acrylic polymer

### (Oxime-based Photopolymerization Initiator)

PBG-305 (Product name, manufactured by CHANGZHOU TRONLY NEW ELECTRONIC MATERIALS CO., LTD)
NCI-831 (ADEKA ARKLS, Product name, manufactured by ADEKA Corporation)
OXE-02 ("IRGACURE", Product name, manufactured by Ciba Japan K.K.)

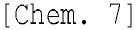

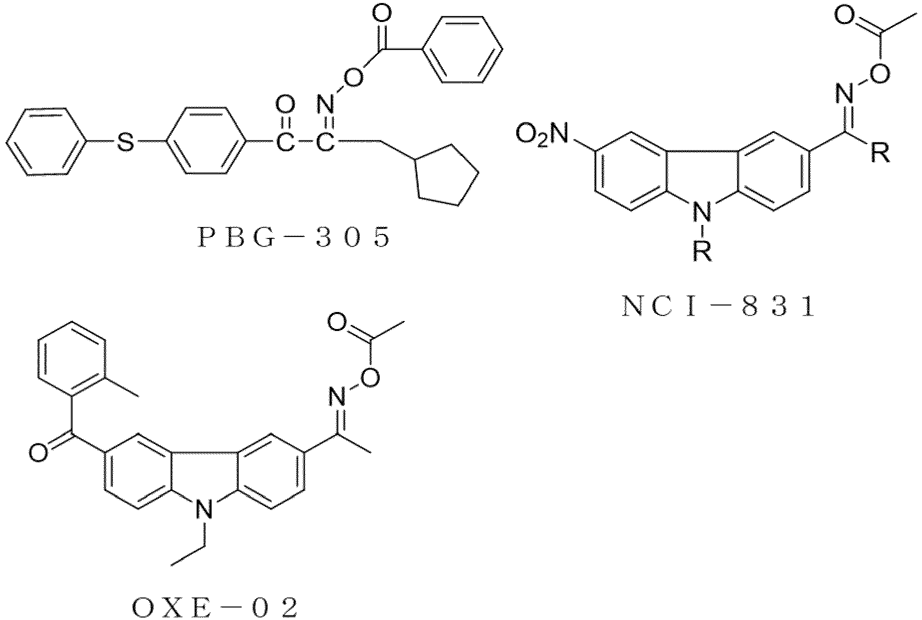

### (Polymerizable compound (acrylic monomer))

BP-6 EM ("Light ester" BP-6EM, Product name, manufactured by Kyoeisha Chemical Co., Ltd.)
M-315 ("Aronix", Product name, manufactured by Toagosei Co., Ltd.)
DCP-A (LIGHT ACRYLATE DCP-A (Product name) manufactured by Kyoeisha Chemical Co., Ltd.)

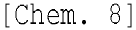

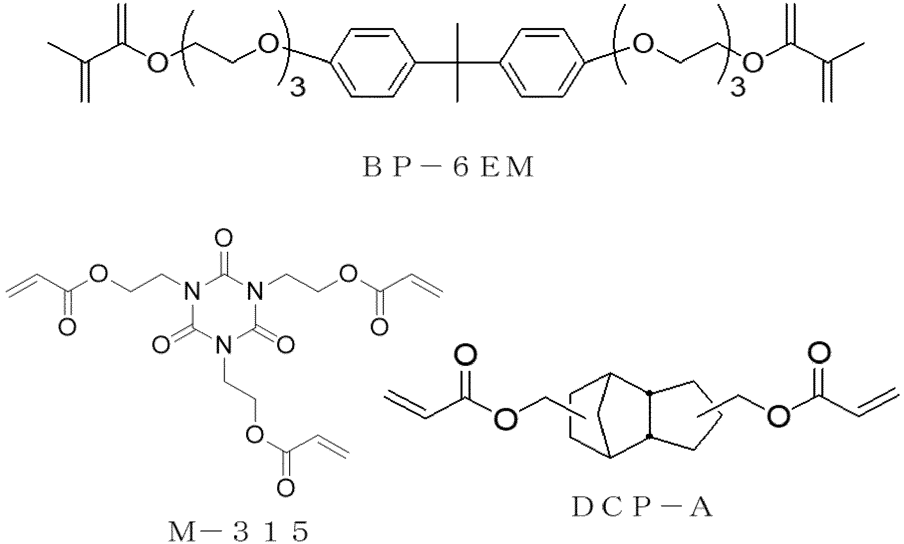

### (Photo acid generator (cationic polymerization initiator)) CPI-310B (Product name, manufactured by San-Apro Ltd.)

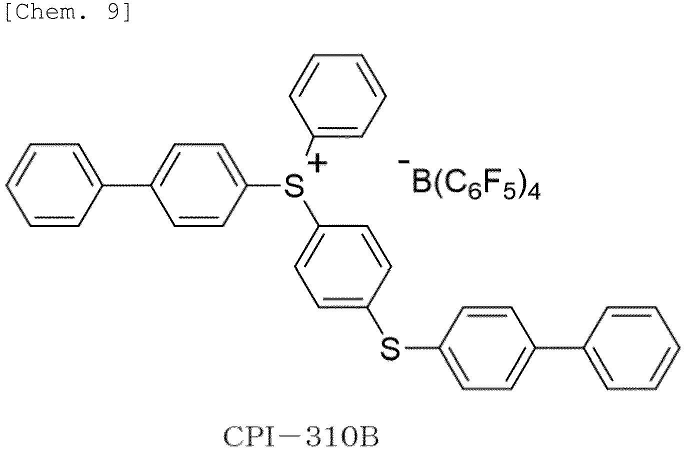

### (Naphthoquinone diazide compound)

Naphthoquinone diazide compound B1
Naphthoquinone diazide compound B2
Naphthoquinone diazide compound B3

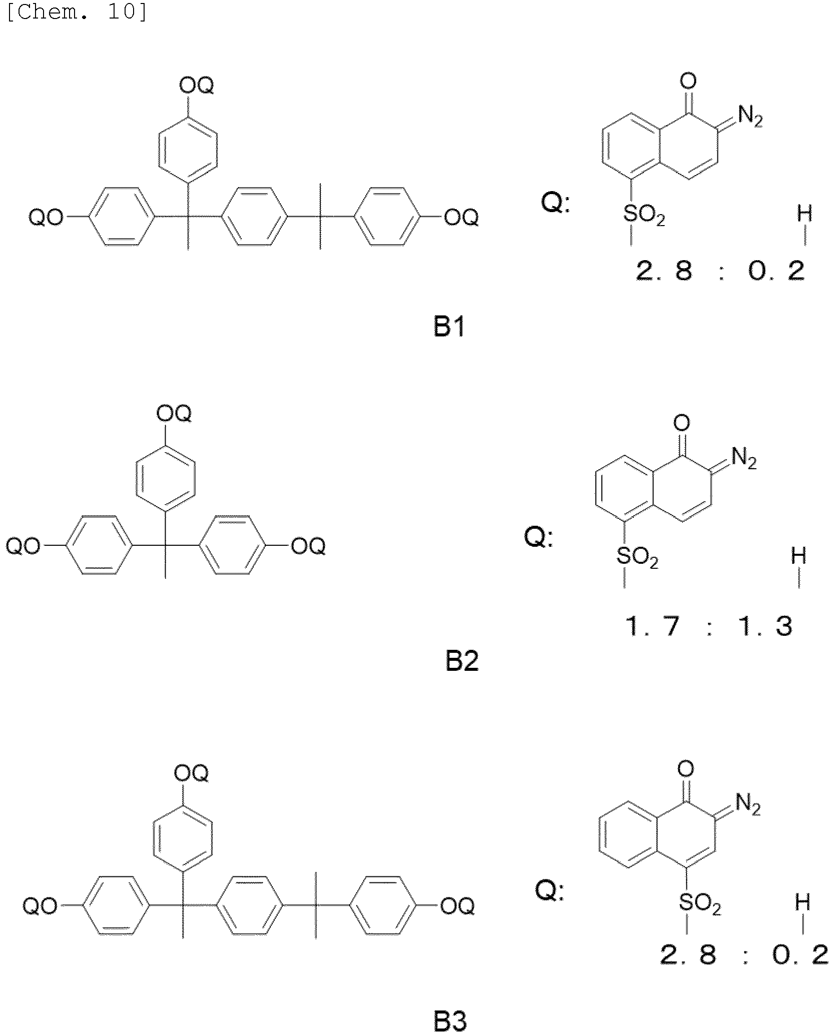

### Synthesis Example 1 Synthesis of dicarboxylic acid derivative (a)

Under a nitrogen stream, 27.2 g (0.4 mol) of imidazole was put in a 250 ml three-necked flask, 100 g of methylene chloride was put, and the mixture was stirred at room temperature. The mixture was cooled to -5°C or less, and a liquid prepared by dispersing 29.5 g (0.1 mol) of 4,4'-diphenyl ether dicarboxylic acid dichloride in 100 g of methylene chloride was added dropwise over 1 hour so that the temperature of the reaction solution was 0°C or less. After the dropping, the reaction solution was stirred at room temperature further for 3 hours, and the precipitate generated during the reaction was filtered. The filtered precipitate was washed with pure water several times and dried in a vacuum oven at 50°C for 100 hours to obtain a dicarboxylic acid derivative (a) represented by the following formula.

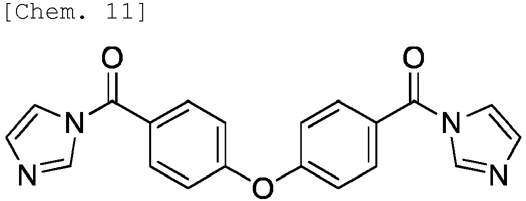

### Synthesis Example 2 Synthesis of polyimide A1 of alkali-soluble resin (A)

Under a dry nitrogen stream, ODPA 15.51 g (0.050 mol) and MAP1.09 g (0.010 mol) were dissolved in 100 g of NMP. To this solution, 15.57 g (0.043 mol) of BAHF and 0.62 g (0.003 mol) of SiDA were added together with 20 g of NMP, and the solution was allowed to react for 1 hour at 60°C and then stirred for 4 hours at 200°C. After completion of the stirring, the solution was charged into 2 L of water to obtain a white precipitate. This precipitate was collected by filtration, washed three times with water, and then dried in a vacuum oven at 50°C for 72 hours to obtain a powder of polyimide A1.

### Synthesis Example 3 Synthesis of alkali-soluble resin (A) polybenzoxazole precursor A2

Under a dry nitrogen stream, BAHF (15.57 g, 0.045 mol) and RT-1000 (5.00 g, 0.0050 mol) were dissolved in 100 g of NMP. Here, the dicarboxylic acid derivative a (15.23 g, 0.043 mol) and 25 g of NMP were added, and the mixture was reacted at 85°C for 3 hours. Next, SiDA (0.62 g, 0.0025 mol), ODPA (0.78 g, 0.0025 mol), NA (2.46 g, 0.015 mol), and 25 g of NMP were added, and the mixture was reacted at 85°C for 1 hour. After the reaction was completed, the mixture was cooled to room temperature, acetic acid (13.20 g, 0.25 mol) and 25 g of NMP were added, and the mixture was stirred at room temperature for 1 hour. After the stirring was completed, the solution was poured into 1.5 L of water to obtain a white precipitate. The precipitate was collected by filtration, washed with water three times, and then dried in a vacuum dryer at 50°C for 3 days to obtain a powder of a polybenzoxazole precursor A2.

### Synthesis Example 4 Synthesis of alkali-soluble resin (A) polyhydroxystyrene A3

Into a mixed solution of 500 ml of tetrahydrofuran and 0.01 mol of sec-butyllithium as an initiator, 20 g in total of p-t-butoxystyrene and styrene are added in a molar ratio of 3 : 1, and polymerized with stirring for 3 hours. The polymerization was terminated by adding 0.1 mol of methanol to the reaction solution. Next, in order to purify the resulting polymer, the reaction mixture was poured into methanol, and the precipitated polymer was then dried to obtain a white polymer. Furthermore, the resulting mixture was dissolved in 400 ml of acetone, a small amount of concentrated hydrochloric acid was added at 60°C and stirred for 7 hours, and then poured into water to precipitate the polymer, and the polymer is converted to hydroxystyrene by deprotecting p-t-butoxystyrene, washed and dried to obtain a polyhydroxystyrene A3 which is a purified copolymer of p-hydroxystyrene and styrene.

### Preparation Examples 1 to 25 Preparation of photosensitive varnishes 1 to 25

Materials for the photosensitive varnish were added as shown in Tables 1 and 2 and stirred to obtain photosensitive varnishes 1 to 25 having a viscosity of 2,000 cP.

### Preparation Examples 26 and 27 Preparation of photosensitive varnishes 26 and 27

Materials for the photosensitive varnish were added as shown in Table 2 and stirred to obtain a photosensitive varnish 25 having a viscosity of 2,000 cP. As the inorganic particles used, glass particles A containing 45 mass% of silicon oxide, 25 mass% of aluminum oxide, 4 mass% of boron oxide, and 26 mass% of yttrium oxide were used. The glass particles A had a refractive index of 1.61 at a wavelength of 405 nm and an average particle diameter of 1.2 um.

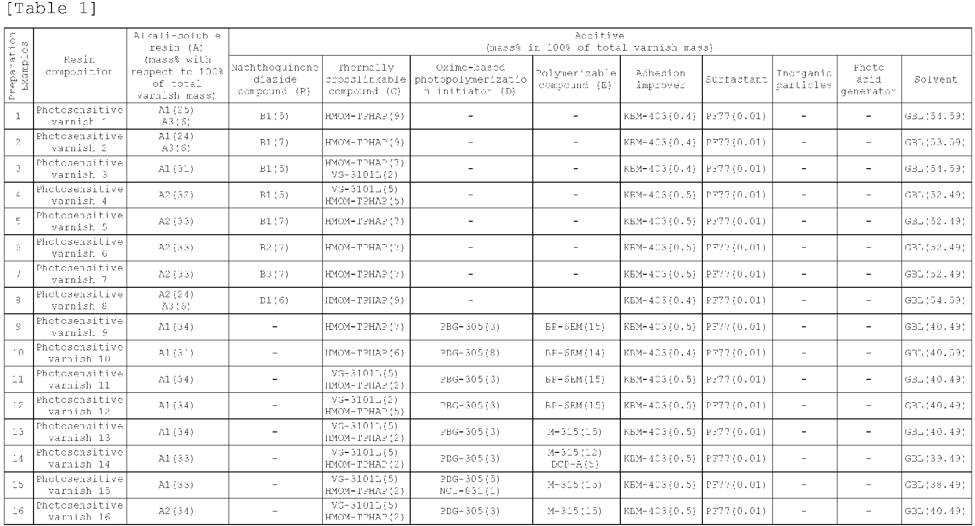

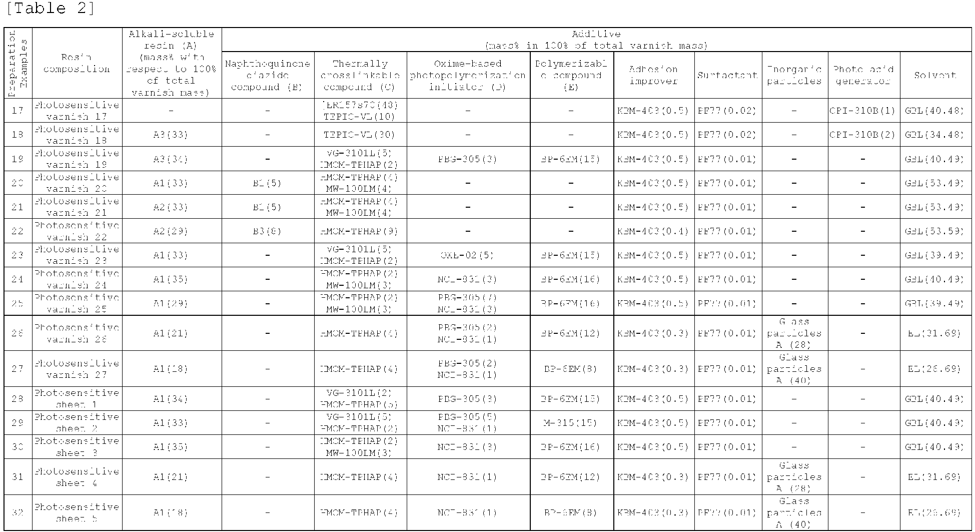

### Preparation Examples 28 to 32 Preparation of photosensitive sheets 1 to 5

A photosensitive varnish material was added as shown in Table 2 and stirred, and the obtained photosensitive varnish was applied onto a PET film having a thickness of 38 um using a comma roll coater, and dried at 80°C for 8 minutes, and then a PP film having a thickness of 10 um was layered as a protective film to obtain photosensitive sheets 1 to 5 having a thickness of 23 um.

Examples 1 to 31 and Comparative Examples 1 to 6 Using the photosensitive varnishes of Preparation Examples 1 to 27 as a material of the organic film (I) and using the photosensitive sheets of Preparation Examples 28 to 32 as a material of the organic film (II), the above (1) and (2) were performed to obtain a hollow structure, and evaluation of (3) to (10) was performed. In only Example 17, in the above (2) Formation of hollow structure, development was performed using propylene glycol monomethyl ether acetate in place of a 2.38 mass% aqueous tetramethylammonium (TMAH) solution. Tables 3 to 5 show combinations of materials of the organic films (I) and (II) and evaluation results.

**[Table 3-1]**

| | Material of organic film (I) | Material of organic film (II) | (3) Corrosion resistance of hollow structure | | (4) Adhesion between hollow structure support material and roof material | (5-1) Acid ion elution amount of organic film (I) | | | | | | (5-1) Conductivity of organic film (I) | |
|---|---|---|---|---|---|---|---|---|---|---|---|---|---|
| | | | Film thickness of copper oxide (nm) | Evaluation | Evaluation | ppm | Evaluation | (Details) Acetate ion | (Details ) Formate ion | (Details) Propionate ion | (Details) Sulfate ion | µs/cm | Evaluation |
| Example 1 | Photosensitive varnish 1 | Photosensitive sheet 1 | 140 | A | B | 130 | A | 10 | 70 | - | 50 | 320 | B |
| Example 2 | Photosensitive varnish 2 | Photosensitive sheet 1 | 170 | B | B | 250 | A | 10 | 100 | 5 | 135 | 400 | B |
| Example 3 | Photosensitive varnish 3 | Photosensitive sheet 1 | 140 | A | B | 120 | A | 20 | 50 | 5 | 45 | 320 | B |
| Example 4 | Photosensitive varnish 4 | Photosensitive sheet 1 | 130 | A | B | 100 | A | 20 | 25 | 5 | 50 | 320 | B |
| Example 5 | Photosensitive varnish 5 | Photosensitive sheet 1 | 150 | A | B | 200 | A | 25 | 50 | 5 | 120 | 370 | B |
| Example 6 | Photosensitive varnish 6 | Photosensitive sheet 1 | 140 | A | B | 200 | A | 30 | 60 | 5 | 105 | 370 | B |
| Example 7 | Photosensitive varnish 7 | Photosensitive sheet 1 | 190 | B | B | 600 | B | 30 | 60 | 5 | 505 | 370 | B |
| Example 8 | Photosensitive varnish 8 | Photosensitive sheet 1 | 150 | A | B | 150 | A | 10 | 100 | - | 40 | 350 | B |
| Example 9 | Photosensitive varnish 9 | Photosensitive sheet 1 | 120 | A | B | 180 | A | 70 | 100 | 10 | - | 300 | A |
| Example 10 | Photosensitive varnish 10 | Photosensitive sheet 1 | 130 | A | B | 180 | A | 80 | 90 | 10 | - | 320 | B |
| Example 11 | Photosensitive varnish 11 | Photosensitive sheet 1 | 100 | A | B | 160 | A | 90 | 60 | 10 | - | 300 | A |
| Example 12 | Photosensitive varnish 12 | Photosensitive sheet 1 | 120 | A | B | 170 | A | 80 | 80 | 10 | - | 300 | A |

**[Table 3-2]**

| | (5-2) Acid ion elution amount of organic film (II) | | (5-2) Conductivity of organic film (II) | | (5-3) Total acid ion elution amount of organic film (I) and organic film (II) | | (6) Evaluation of cross-sectional shape of organic film (I) | | (7) Weight loss temperature of organic film (I) | | (8) Elastic modulus of organic film (I) | (9) Elastic modulus of organic film (II) | (10) Sealing ratio of hollow structure | |
|---|---|---|---|---|---|---|---|---|---|---|---|---|---|---|
| | ppm | Evaluation | pS/cm | Evaluation | ppm | Evaluation | y/x | Evaluatio n | °C | Evaluation | GPa | GPa | % | Evaluation |
| Example 1 | 160 | A | 300 | A | 290 | A | 0.6 | B | 330 | B | 3.5 | 3.5 | 80 | B |
| Example 2 | 160 | A | 300 | A | 410 | A | 0.6 | B | 330 | B | 3.5 | 3.5 | 80 | B |
| Example 3 | 160 | A | 300 | A | 280 | A | 0.6 | B | 360 | A | 3.0 | 3.5 | 80 | B |
| Example 4 | 160 | A | 300 | A | 260 | A | 0.7 | B | 350 | A | 2.5 | 3.5 | 75 | B |
| Example 5 | 160 | A | 300 | A | 360 | A | 0.6 | B | 350 | A | 2.5 | 3.5 | 75 | B |
| Example 6 | 160 | A | 300 | A | 360 | A | 0.6 | B | 350 | A | 2.5 | 3.5 | 75 | B |
| Example 7 | 160 | A | 300 | A | 760 | A | 0.6 | B | 350 | A | 2.5 | 3.5 | 75 | B |
| Example 8 | 160 | A | 300 | A | 310 | A | 0.6 | B | 330 | B | 3.5 | 3.5 | 80 | B |
| Example 9 | 160 | A | 300 | A | 340 | A | 0.8 | A | 350 | A | 3.5 | 3.5 | 80 | B |
| Example 10 | 160 | A | 300 | A | 340 | A | 0.8 | A | 350 | A | 3.5 | 3.5 | 80 | B |
| Example 11 | 160 | A | 300 | A | 320 | A | 0.8 | A | 350 | A | 3.5 | 3.5 | 80 | B |
| Example 12 | 160 | A | 300 | A | 330 | A | 0.8 | A | 350 | A | 3.5 | 3.5 | 80 | B |

**[Table 4-1]**

| | Material of organic film (I) | Material of organic film (II) | (3) Corrosion resistance of hollow structure | | (4) Adhesion between hollow structure support material and roof material | (5-1) Acid ion elution amount of organic film (I) | | | | | | (5-1) Conductivity of organic film (I) | |
|---|---|---|---|---|---|---|---|---|---|---|---|---|---|
| | | | Film thickness of copper oxide (nm) | Evaluation | Evaluation | ppm | Evaluation | (Details ) Acetate ion | (Details ) Formate ion | (Details) Propionate ion | (Details) Sulfate ion | pS/cm | Evaluation |
| Example 13 | Photosensitive varnish 13 | Photosensitive sheet 1 | 100 | A | A | 190 | A | 80 | 100 | 10 | - | 300 | A |
| Example 14 | Photosensitive varnish 14 | Photosensitive sheet 1 | 100 | A | A | 180 | A | 90 | 80 | 10 | | 300 | A |
| Example 15 | Photosensitive varnish 15 | Photosensitive sheet 1 | 160 | B | A | 500 | A | 400 | 90 | 10 | - | 400 | B |
| Example 16 | Photosensitive varnish 16 | Photosensitive sheet 1 | 120 | A | A | 200 | A | 100 | 90 | 10 | - | 300 | A |
| Example 17 | Photosensitive varnish 17 | Photosensitive sheet 1 | 190 | B | A | 1510 | B | 305 | 1200 | 5 | - | 420 | B |
| Example 18 | Photosensitive varnish 18 | Photosensitive sheet 1 | 190 | B | A | 1805 | B | 300 | 1500 | 5 | - | 420 | B |
| Example 19 | Photosensitive varnish 19 | Photosensitive sheet 1 | 160 | B | B | 405 | A | 300 | 100 | 5 | - | 400 | B |
| Example 20 | Photosensitive varnish 11 | Photosensitive sheet 2 | 160 | B | A | 160 | A | 90 | 60 | 10 | - | 300 | A |
| Example 21 | Photosensitive varnish 11 | Photosensitive sheet 3 | 200 | B | A | 160 | A | 90 | 60 | 10 | - | 300 | A |
| Example 22 | Photosensitive varnish 20 | Photosensitive sheet 1 | 220 | C | B | 2160 | B | 90 | 2000 | 10 | 60 | 530 | C |
| Example 23 | Photosensitive varnish 21 | Photosensitive sheet 1 | 230 | C | B | 2180 | B | 120 | 2000 | 10 | 50 | 530 | C |
| Example 24 | Photosensitive varnish 22 | Photosensitive sheet 1 | 220 | C | B | 1100 | B | 60 | 100 | 10 | 930 | 500 | B |
| Example 25 | Photosensitive varnish 23 | Photosensitive sheet 1 | 240 | C | B | 2400 | C | 2300 | 90 | 10 | - | 480 | B |
| Example 26 | Photosensitive varnish 25 | Photosensitive sheet 1 | 240 | C | B | 3510 | C | 1700 | 1800 | 10 | < | 570 | C |

**[Table 4-2]**

| | (5-2) Acid ion elution amount of organic film (II) | | (5-2) Conductivity of organic film (II) | | (5-3) Total acid ion elution amount of organic film (I) and organic film (II) | | (6) Evaluation of cross-sectional shape of organic film (I) | | (7) Weight loss temperature of organic film (I) | | (8) Elastic modulus of organic film (I) | (9) Elastic modulus of organic film (II) | (10) Sealing ratio of hollow structure | |
|---|---|---|---|---|---|---|---|---|---|---|---|---|---|---|
| | ppm | Evaluation | uS/cm | Evaluation | ppm | Evaluation | y/x | Evaluation | °C | Evaluation | GPa | GPa | % | Evaluation |
| Example 13 | 160 | A | 300 | A | 350 | A | 0.9 | A | 380 | A | 3.5 | 3.5 | 80 | B |
| Example 14 | 160 | A | 300 | A | 340 | A | 0.9 | A | 360 | A | 3.5 | 3.5 | 80 | B |
| Example 15 | 160 | A | 300 | A | 660 | A | 0.9 | A | 370 | A | 3.5 | 3.5 | 80 | B |
| Example 16 | 160 | A | 300 | A | 360 | A | 0.9 | A | 370 | A | 3.0 | 3.5 | 80 | B |
| Example 17 | 160 | A | 300 | A | 1670 | B | 1 | A | 310 | B | 3.0 | 3.5 | 80 | B |
| Example 18 | 160 | A | 300 | A | 1965 | B | 1 | A | 300 | B | 3.5 | 3.5 | 80 | B |
| Example 19 | 160 | A | 300 | A | 565 | A | 0.9 | A | 290 | C | 3.5 | 3.5 | 80 | B |
| Example 20 | 500 | A | 300 | A | 660 | A | 0.9 | A | 350 | A | 3.5 | 3.5 | 80 | B |
| Example 21 | 3410 | C | 560 | C | 3570 | B | 0.9 | A | 350 | A | 3.5 | 3.5 | 80 | B |
| Example 22 | 160 | A | 300 | A | 2320 | B | 0.6 | B | 360 | A | 3.0 | 3.5 | 80 | B |
| Example 23 | 160 | A | 300 | A | 2340 | B | 0.6 | B | 350 | A | 3.5 | 3.5 | 80 | B |
| Example 24 | 160 | A | 300 | A | 1260 | B | 0.6 | B | 350 | A | 3.5 | 3.5 | 80 | B |
| Example 25 | 160 | A | 300 | A | 2560 | B | 0.6 | B | 350 | A | 3.5 | 3.5 | 80 | B |
| Example 26 | 160 | A | 300 | A | 3670 | B | 0.9 | A | 350 | A | 3.5 | 3.5 | 80 | B |

**[Table 5-1]**

| | Material of organic film (I) | Material of organic film (II) | (3) Corrosion resistance of hollow structure | | (4) Adhesion between hollow structure support material and roof material | (5-1) Acid ion elution amount of organic film (I) | | | | | | (5-1) Conductivity of organic film (I) | |
|---|---|---|---|---|---|---|---|---|---|---|---|---|---|
| | | | Film thickness of copper oxide (nm) | Evaluation | Evaluation | ppm | Evaluation | (Details) Acetate ion | (Details) Formate ion | (Details) Propionate ion | (Details) Sulfate ion | µs/cm | Evaluation |
| Example 27 | Photosensitive varnish 26 | Photosensitive sheet 1 | 160 | B | B | 470 | A | 365 | 100 | 5 | - | 400 | B |
| Example 28 | Photosensitive varnish 27 | Photosensitive sheet 1 | 160 | B | B | 455 | A | 350 | 100 | 5 | - | 400 | B |
| Example 29 | Photosensitive varnish 11 | Photosensitive sheet 4 | 160 | B | B | 160 | A | 90 | 60 | 10 | - | 300 | A |
| Example 30 | Photosensitive varnish 11 | Photosensitive sheet 5 | 200 | B | A | 160 | A | 90 | 60 | 10 | - | 300 | A |
| Example 31 | Photosensitive varnish 26 | Photosensitive sheet 5 | 170 | B | B | 470 | A | 365 | 100 | 5 | - | 400 | B |
| Comparative Example 1 | Photosensitive varnish 20 | Photosensitive sheet 3 | 250 | C | B | 2160 | B | 90 | 2000 | 10 | 60 | 530 | C |
| Comparative Example 2 | Photosensitive varnish 21 | Photosensitive sheet 3 | 250 | C | B | 2180 | B | 120 | 2000 | 10 | 50 | 530 | C |
| Comparative Example 3 | Photosensitive varnish 22 | Photosensitive sheet 3 | 250 | C | B | 1100 | B | 60 | 100 | 10 | 930 | 500 | B |
| Comparative Example 4 | Photosensitive varnish 23 | Photosensitive sheet 3 | 250 | C | B | 2400 | C | 2300 | 90 | 10 | - | 480 | B |
| Comparative Example 5 | Photosensitive varnish 25 | Photosensitive sheet 3 | 260 | C | B | 3510 | C | 1700 | 1800 | 10 | - | 570 | C |
| Comparative Example 6 | Photosensitive varnish 24 | Photosensitive sheet 3 | 250 | C | B | 3410 | C | 1600 | 1800 | 10 | - | 560 | C |

**[Table 5-2]**

| | (5-2) Acid ion elution amount of organic film (II) | | (5-2) Conductivity of organic film (II) | | (5-3) Total acid ion elution amount of organic film (I) and organic film (II) | | (6) Evaluation of cross-sectional shape of organic film (I) | | (7) Weight loss temperature of organic film (I) | | (8) Elastic modulus of organic film (I) | (9) Elastic modulus of organic film (II) | (10) Sealing ratio of hollow structure | |
|---|---|---|---|---|---|---|---|---|---|---|---|---|---|---|
| | ppm | Evaluation | pS/cm | Evaluation | ppm | Evaluation | y/x | Evaluation | °C | Evaluation | GPa | GPa | % | Evaluation |
| Example 27 | 160 | A | 300 | A | 630 | A | 0.9 | A | 350 | A | 7.0 | 3.5 | 85 | B |
| Example 28 | 160 | A | 300 | A | 615 | A | 0.9 | A | 360 | A | 10 | 3.5 | 85 | B |
| Example 29 | 1600 | B | 500 | B | 1760 | B | 0.9 | A | 370 | A | 3.5 | 7.0 | 90 | A |
| Example 30 | 1500 | B | 500 | B | 1660 | B | 0.9 | A | 350 | A | 3.5 | 12 | 95 | A |
| Example 31 | 1600 | B | 500 | B | 2070 | B | 0.9 | A | 350 | A | 7.0 | 12 | 100 | A |
| Comparative Example 1 | 3410 | C | 560 | C | 5570 | C | 0.6 | B | 360 | A | 3.0 | 3.5 | 80 | B |
| Comparative Example 2 | 3410 | C | 560 | C | 5590 | C | 0.6 | B | 350 | A | 3.5 | 3.5 | 80 | B |
| Comparative Example 3 | 3410 | C | 560 | C | 4510 | C | 0.6 | B | 350 | A | 3.5 | 3.5 | 80 | B |
| Comparative Example 4 | 3410 | C | 560 | C | 5810 | C | 0.6 | B | 350 | A | 3.5 | 3.5 | 80 | B |
| Comparative Example 5 | 3410 | C | 560 | C | 6920 | C | 0.9 | A | 360 | A | 3.5 | 3.5 | 80 | B |
| Comparative Example 6 | 3410 | C | 560 | C | 6820 | C | 0.6 | B | 350 | A | 3.5 | 3.5 | 80 | B |

### DESCRIPTION OF REFERENCE SIGNS

1: Substrate
1(a): Upper surface of substrate
2: Organic film (I)
2(a): Wall surface of organic film (I)
3: Organic film (II)
4: Metal wiring (Al, Cu, or the like)

## Claims

1. A hollow structure in which
an organic film (I) having a film thickness of 5 to 30 um as a hollow structure support material; and
an organic film (II) having a film thickness of 5 to 30 um as a hollow structure roof material are layered in this order from an upper surface of a substrate having a metal wiring,
wherein
when the organic film (I) and the organic film (II) are independently evaluated by the following ion elution amount evaluation method, a total of the ion elution amount of the organic film (I) and the ion elution amount of the organic film (II) is 4,000 ppm or less:
ion elution amount evaluation method wherein
an organic film is placed in pure water having a mass of 10 times that of the organic film, and is extracted in hot water for 10 to 20 hours at 100 to 121°C, after which the supernatant of the liquid extract is used as a sample solution, the sample solution and a target ion standard solution are introduced into an ion chromatography device, the concentrations of formate ions, acetate ions, propionate ions, and sulfate ions in the sample solution are determined by a calibration curve method, and a value obtained by converting the total concentrations into the mass of eluted ions relative to the mass of the organic film is used as the ion elution amount.

2. The hollow structure according to claim 1, wherein an ion elution amount when the organic film (I) is evaluated by the ion elution amount evaluation method is 2,000 ppm or less.

3. The hollow structure according to claim 1 or 2, wherein an ion elution amount when the organic film (II) is evaluated by the ion elution amount evaluation method is 2,000 ppm or less.

4. The hollow structure according to any one of claims 1 to 3, wherein the conductivity of a sample solution of the organic film (I) obtained by the ion elution amount evaluation method is 500 µs/cm or less.

5. The hollow structure according to any one of claims 1 to 4, wherein the conductivity of a sample solution of the organic film (II) obtained by the ion elution amount evaluation method is 500 µs/cm or less.

6. The hollow structure according to any one of claims 1 to 5, wherein
the organic film (I) contains a cured product obtained by curing a positive photosensitive resin composition containing
at least one alkali-soluble resin (A) selected from the group consisting of polyimide, polybenzoxazole, polyamide, any of precursors thereof, and copolymers thereof,
a naphthoquinone diazide compound (B), and
a thermally crosslinkable compound (C).

7. The hollow structure according to claim 6, wherein the naphthoquinone diazide compound (B) contains a compound represented by formula (1) and/or formula (2).

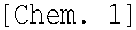

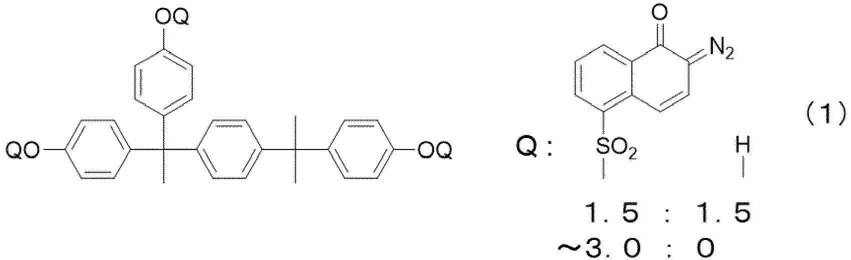

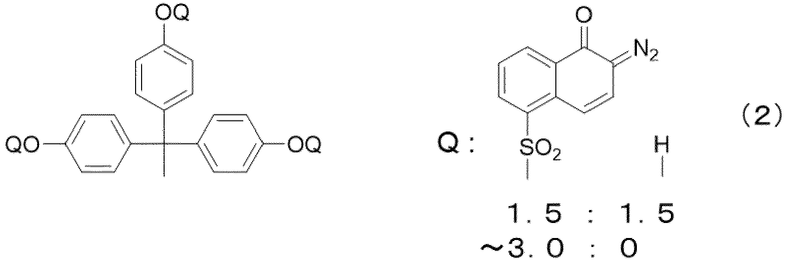

8. The hollow structure according to any one of claims 1 to 5,
wherein the organic film (I) contains a cured product obtained by curing a negative photosensitive resin composition containing
at least one alkali-soluble resin (A) selected from the group consisting of polyimide, polybenzoxazole, polyamide, any of precursors thereof, and copolymers thereof,
a thermally crosslinkable compound (C),
an oxime-based photopolymerization initiator (D), and
a polymerizable compound (E), wherein the oxime-based photopolymerization initiator (D) contains a compound represented by the formula (3), 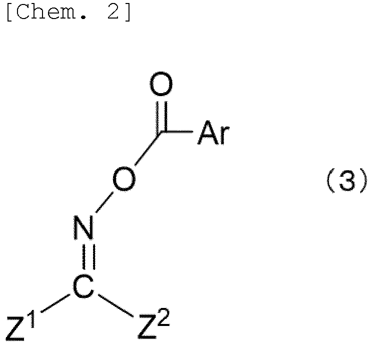
the formula (3) shown above wherein Ar represents an aryl group, Z¹ represents an organic group having 6 to 20 carbon atoms, and Z² represents a hydrogen atom or an organic group having 1 to 20 carbon atoms.

9. The hollow structure according to claim 8,
wherein the polymerizable compound (E) contains a compound represented by formula (4), and
55 to 90 mass% of the compound represented by the formula (4) is contained based on 100 mass% of the total amount of the polymerizable compound (E).

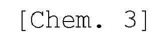

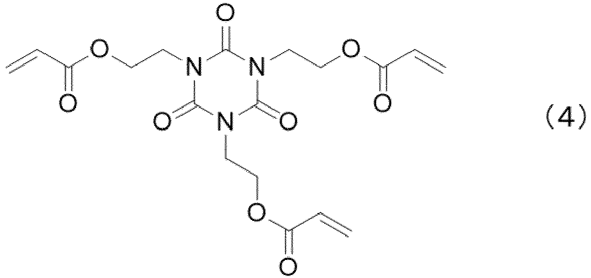

10. The hollow structure according to any one of claims 6 to 9, wherein the thermally crosslinkable compound (C) contains a polyfunctional epoxy group-containing compound (C-1) and a polyfunctional alkoxymethyl group-containing compound (C-2), and the content of the polyfunctional epoxy group-containing compound (C-1) is 5 to 30 parts by mass and the content of the polyfunctional alkoxymethyl group-containing compound (C-2) is 1 to 10 parts by mass based on 100 parts by mass of the alkali-soluble resin (A).

11. The hollow structure according to any one of claims 1 to 10, wherein the organic film (I) contains 30 to 80 mass% of inorganic particles in 100 mass% of the organic film (I), and the organic film (II) contains 0 to 80 mass% of inorganic particles in 100 mass% of the organic film (II), or the organic film (II) contains 30 to 80 mass% of inorganic particles in 100 mass% of the organic film (II), and the organic film (I) contains 0 to 80 mass% of inorganic particles in 100 mass% of the organic film (I).

12. The hollow structure according to claim 11, wherein the inorganic particles are glass particles having a refractive index of 1.55 to 1.75.

13. The hollow structure according to any one claims 1 to 12, wherein in a cross section perpendicular to the upper surface of the substrate and the wall surface of the organic film (I), when a length of a ground contact surface between the organic film (I) and the substrate is set as x and a length of a ground contact surface between the organic film (I) and the organic film (II) is set as y, 1 ≥ y/x ≥ 0.6 is satisfied.

14. An electronic component comprising the hollow structure according to any one of claims 1 to 13.

15. A negative photosensitive resin composition comprising:
at least one alkali-soluble resin (A) selected from the group consisting of polyimide, polybenzoxazole, polyamide, any of precursors thereof, and copolymers thereof;
a thermally crosslinkable compound (C);
an oxime-based photopolymerization initiator (D); and
a polymerizable compound (E),
wherein the content of the oxime-based photopolymerization initiator (D) is 1 to 20 parts by mass based on 100 parts by mass of the alkali-soluble resin (A), and the compound represented by formula (3) is contained in an amount of 70 to 100 mass% based on 100 mass% of the total amount of the oxime-based photopolymerization initiator (D), 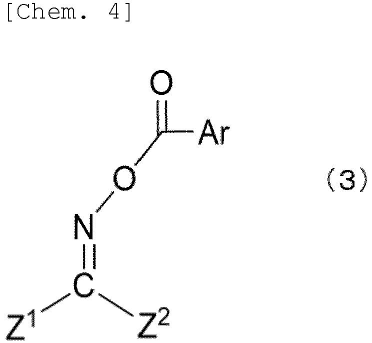
the formula (3) shown above wherein Ar represents an aryl group, Z¹ represents an organic group having 6 to 20 carbon atoms, and Z² represents a hydrogen atom or an organic group having 1 to 20 carbon atoms.

16. The negative photosensitive resin composition according to claim 15,
wherein, the polymerizable compound (E) contains a compound represented by formula (4), and
55 to 90 mass% of the compound represented by the formula (4) is contained based on 100 mass% of the total amount of the polymerizable compound (E).

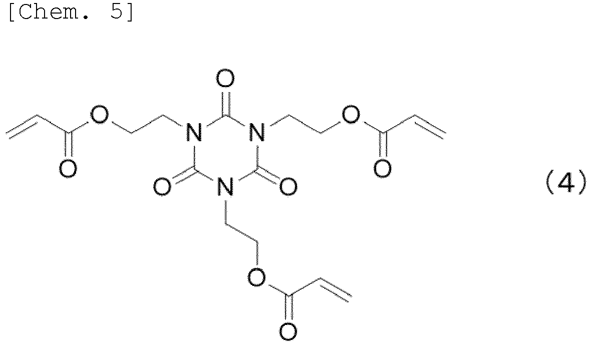

17. The negative photosensitive resin composition according to claim 15 or 16, wherein the thermally crosslinkable compound (C) contains a polyfunctional epoxy group-containing compound (C-1) and a polyfunctional alkoxymethyl group-containing compound (C-2), and the content of the polyfunctional epoxy group-containing compound (C-1) is 5 to 30 parts by mass and the content of the polyfunctional alkoxymethyl group-containing compound (C-2) is 1 to 10 parts by mass based on 100 parts by mass of the alkali-soluble resin (A).
